# EUROPÄISCHE PATENTANMELDUNG

(11) **EP 1 074 366 A1**
(43) Veröffentlichungstag der Anmeldung: **07.02.2001**
(21) Anmeldenummer: 00114192.8
(22) Anmeldetag: 13.07.2000
(51) Int. Cl.: B28D 5/04, B23D 57/00

(54) **Sägedraht und Verfahren zum Trennläppen von sprödharten Werkstücken**

(30) Priorität: 05.08.1999 DE 19936834
(71) Anmelder: Wacker Siltronic Gesellschaft für Halbleitermaterialien Aktiengesellschaft, 84489 Burghausen (DE)
(72) Erfinder: Käser, Maximilian, 84489 Burghausen (DE); Andrä, Christian, 84577 Tüssling (DE)
(74) Vertreter: Rimböck, Karl-Heinz, Dr.

(57) **Zusammenfassung**

Gegenstand der Erfindung ist ein Sägedraht zum gleichzeitigen Trennläppen von einer Vielzahl von Scheiben von einem sprödharten Werkstück. Der Sägedraht ist dadurch gekennzeichnet, daß er eine Torsion aufweist. Gegenstand der Erfindung ist auch ein Verfahren zum gleichzeitigen Trennläppen von einer Vielzahl von Scheiben von einem sprödharten Werkstück unter Verwendung eines Sägedrahtes, der spiralförmig über Drahtführungsrollen läuft und ein Drahtgatter bildet und eines Trennläppmittels in einer Drahtsäge, dadurch gekennzeichnet, daß der Sägedraht während des Trennläppens eine Rotationsbewegung ausführt.

## Beschreibung

Gegenstand der Erfindung ist ein Sägedraht zum gleichzeitigen Trennläppen von einer Vielzahl von Scheiben von einem sprödharten Werkstück. Gegenstand der Erfindung ist auch ein Verfahren zum Trennläppen unter Verwendung eines Sägedrahtes.

Eine Drahtsäge, die insbesondere für die Herstellung von Halbleiterscheiben geeignet ist, und das, einer Drahtsäge zugrunde liegende Funktionsprinzip ist beispielsweise in der US-5,771,876 beschrieben.

In der Regel sind Drahtsägen mit Drahtführungsrollen ausgestattet, über die ein endlicher Sägedraht spiralförmig geführt wird, so daß eine Sägeharfe bzw. ein Schneid- oder Drahtgatter entsteht. Das Werkstück wird mit einer Vorschubbewegung durch das Drahtgatter geführt und beim Durchdringen des Gatters in Scheiben geteilt. Der Sägedraht wird entweder über den ganzen Schnittverlauf in die gleiche Richtung oder hin und her bewegt (oszillierende Drahtbewegung). Als Trennläppmittel werden Schneidkörnungen in unterschiedlichen Korngrößen und unterschiedlicher Härte verwendet, die in einer Trägerflüssigkeit suspendiert sind.

Die Qualität des Schnittes, d.h. die Qualität der Scheibenoberflächen und der Scheibengeometrien hängt zunächst von einer gleichmäßigen Verteilung des Trennläppmittels entlang der Gatterbreite ab. Sägedrähte gemäß dem Stand der Technik befördern aber in der Regel die auf dem Drahtgatter angebotene Menge an Trennläppmittel nicht optimal in den Schneidspalt.

Aufgabe der Erfindung ist es die genannten Nachteile des Standes der Technik zu vermeiden und die Geometrie der Scheiben sowie Oberflächenparameter, wie Riefigkeit, Rauhigkeit und Welligkeit zu verbessern und die Prozeßzeiten zu verkürzen.

Gelöst wird die Aufgabe durch ein Verfahren zum gleichzeitigen Trennläppen von einer Vielzahl von Scheiben von einem sprödharten Werkstück unter Verwendung eines Sägedrahtes, der spiralförmig über Drahtführungsrollen läuft und ein Drahtgatter bildet und eines Trennläppmittels in einer Drahtsäge, dadurch gekennzeichnet, daß der Sägedraht während des Trennläppens eine Rotationsbewegung ausführt.

Überraschenderweise wurde gefunden, daß die Verwendung eines Sägedrahtes mit einer definierten Torsion zu einer Rotation des Drahtes während des Trennläppens führt. Diese Rotationsbewegung, die mit einer Bohrbewegung vergleichbar ist, begünstigt die Verteilung des Trennläppmittels auf dem Drahtgatter und insbesondere die Trennläppmittelversorgung im Schneidspalt. Vorzugsweise rotiert der Sägedraht während er über das Drahtgatter geführt wird. Der Sägedraht rotiert bevorzugt 1 bis 10 mal und besonders bevorzugt 2 bis 5 mal auf einer Drahtlänge von 1500 mm.

Gelöst wird die Aufgabe der Erfindung demnach auch durch einen Sägedraht zum gleichzeitigen Trennläppen von einer Vielzahl von Scheiben von einem sprödharten Werkstück, dadurch gekennzeichnet, daß der Sägedraht eine Torsion aufweist.

Die Torsion des Sägedrahtes wird durch eine Verdrehung des Drahtes um die eigene Achse erzeugt, beispielsweise durch eine entgegengesetzte Drehung von beiden Enden her. Bevorzugt ist die Torsion des Sägedrahtes durch ein Umspulen mit einem Abwickelarm zu erzeugen, beispielsweise indem ein Sägedraht gemäß dem Stand der Technik von einer Drahtspule mittels einer Abwickelvorrichtung, einem sogenannten Flyer, abgewickelt und auf eine Sägedrahtspule vertikal oder horizontal wieder aufgewickelt wird. Durch dieses Ab- und Aufwickeln erhält der Sägedraht eine definierte Torsion. Die Sägedrahtspule mit dem erfindungsgemäßen Sägedraht wird dann als sogenannte Quell- oder Geberspule in einer Drahtsäge gemäß dem Stand der Technik eingesetzt.

Bevorzugt ist aber auch eine Sägedrahtspule mit einem Sägedraht gemäß dem Stand der Technik als Quell- oder Geberspule in einer Drahtsäge einzusetzen und mittels einer Drillvorrichtung den Sägedraht zu verdrehen. Die Drillvorrichtung ist zweckmäßigerweise vor oder nach dem Drahtgatter positioniert.

Auf einer Sägedrahtlänge bevorzugt von 150 bis 1500 mm und besonders bevorzugt von 300 bis 1000 mm beträgt die Torsion des Sägedrahtes 360°. Auf einer Drahtlänge bevorzugt von 150 bis 1500 mm und besonders bevorzugt von 300 bis 1000 mm wird ein Sägedraht mittels einer Drillvorrichtung um 360° verdreht. Zweckmäßigerweise ist die Drillvorrichtung vor oder nach dem Drahtgatter positioniert. Als Sägedrähte werden beschichtete oder unbeschichtete Drähte mit einer Dicke von 80 bis 500 µm und einer Zugfestigkeit von > 2000 N/mm² verwendet.

Die Rotation des erfindungsgemäßen Sägedrahtes während des Trennläppens, insbesondere von sprödharten Werkstücken führt zu einer verbesserten Oberflächenqualität der Scheiben, insbesondere zu einer geringeren Rauhigkeit und Welligkeit. Darüber hinaus werden verbesserte Geometriewerte (Keiligkeit) und verkürzte Prozeßzeiten erzielt.

### Beispiel:

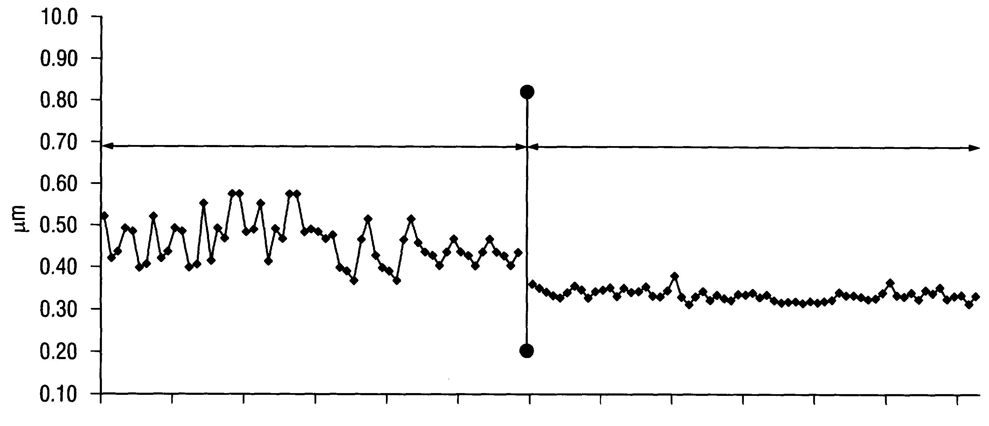

In der Figur ist die Leistungsfähigkeit des erfindungsgemäßen Sägedrahtes und des Verfahrens anhand der Rauhigkeitsverteilung dargestellt.

Durch die Verwendung des erfindungsgemäßen Sägedrahtes sind Qualitätsschwankungen im Hinblick auf die trenngeläppten Scheibenoberflächen und Scheibengeometrien reduziert. Mit einem Perthometer wurde an 5 Meßpunkten die Rauhigkeit der Scheibenoberfläche einer Scheibe eines trenngeläppten Halbleiterstabes bestimmt. Aus den 5 Meßwerten wurde der Mittelwert gebildet. Dieser Mittelwert findet sich in der Figur als Punkt. Die Oberflächen der Scheiben, die mittels Trennläppen mit einem Sägedraht gemäß dem Stand der Technik hergestellt wurden weisen eine Rauhigkeitsverteilung zwischen 0,40 und 0,60 µm auf (links). Die Oberflächen der Scheiben, die mittels Trennläppen mit dem erfindungsgemäßen Sägedraht hergestellt wurden weisen keine Rauhigkeitsverteilung mehr auf. Die Rauhigkeit ist konstant und beträgt etwa 0,32 µm (rechts). Der erfindungsgemäße Sägedraht hatte auf eine Drahtlänge von 700 mm eine Torsion von 360° und wurde in einer Drahtsäge gemäß dem Stand der Technik eingesetzt.

Der erfindungsgemäße Sägedraht wird vorteilhaft in Drahtsägen zum Trennläppen von sprödharten Werkstücken, insbesondere Halbleiterstäben eingesetzt.

## Patentansprüche

1. Verfahren zum gleichzeitigen Trennläppen von einer Vielzahl von Scheiben von einem sprödharten Werkstück unter Verwendung eines Sägedrahtes, der spiralförmig über Drahtführungsrollen läuft und ein Drahtgatter bildet und eines Trennläppmittels in einer Drahtsäge, dadurch gekennzeichnet, daß der Sägedraht während des Trennläppens eine Rotationsbewegung ausführt.

2. Sägedraht zum gleichzeitigen Trennläppen von einer Vielzahl von Scheiben von einem sprödharten Werkstück unter Verwendung eines Trennläppmittels in einer Drahtsäge, dadurch gekennzeichnet, daß der Sägedraht eine Torsion aufweist.

3. Sägedraht nach Anspruch 2, dadurch gekennzeichnet, daß die Torsion auf einer Drahtlänge von 150 bis 1500 mm 360° beträgt.
